(19) Europäisches Patentamt

European Patent Office

Office européen des brevets

(11) Veröffentlichungsnummer: **0 255 073 B1**

## (12) EUROPÄISCHE PATENTSCHRIFT

(45) Veröffentlichungstag der Patentschrift: **01.12.93**

(21) Anmeldenummer: **87110808.0**

(22) Anmeldetag: **25.07.87**

(51) Int. Cl.⁵: **H01L 27/01**, H05K 1/16

(54) Schaltungsanordnung und Resonanzetikette sowie Verfahren zu ihrer Herstellung.

(30) Priorität: **30.07.86 CH 3103/86**

(43) Veröffentlichungstag der Anmeldung:
**03.02.88 Patentblatt 88/05**

(45) Bekanntmachung des Hinweises auf die
Patenterteilung:
**01.12.93 Patentblatt 93/48**

(84) Benannte Vertragsstaaten:
**BE DE ES FR GB IT NL SE**

(56) Entgegenhaltungen:
**WO-A-82/00541**
**WO-A-83/01697**
**FR-A- 2 577 067**
**US-A- 3 921 167**

(73) Patentinhaber: **Actron Entwicklungs AG**
**Lettenstrasse 8**
**CH-6343 Rotkreuz(CH)**

(72) Erfinder: **Jorgensen, Paul Richter**
**La Romantica 8**
**Urb. Los Pinos**
**Almunecar(ES)**

(74) Vertreter: **Lauer, Joachim, Dr.**
**Hug Interlizenz AG**
**Austrasse 44**
**Postfach**
**CH-8045 Zürich (CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Eine Schaltungsanordnung wie diejenige, auf die im Oberbegriff des Anspruches 1 Bezug genommen wird, kann verschiedenen Zwecken dienen, wird aber insbesondere für Resonanzetiketten angewendet. Zu deren Herstellung sind Verfahren beispielsweise in den Druckschriften US-A-3 913 219 oder WO-A-82/00541 (& 4 369 557) vorgeschlagen worden. Im einen Falle wird ein isolierendes Trägermaterial an beiden Seiten mit den zusammengehörigen Flächenabschnitten des Schaltungsmusters versehen, im anderen Falle werden die beiden Flächenabschnitte nebeneinander auf dem Trägermaterial aufgebracht und dieses dann so gefaltet, dass zwischen den beiden Flächenabschnitten des Schalungsmusters eine doppelte Lage des isolierenden Trägermaterials zu liegen kommt. Es ist weiterhin aus der WO-A-82/00541 bekannt, die Trägerfolie so zu falten, dass sich die Flächen der nebeneinander aufgebrachten Flächenabschnitte direkt gegenüberliegen. Als Isolierschicht wird dann eine separate Folie dazwischengeschoben, welche etwa die gleiche Dicke hat wie die Trägerfolie selbst.

Das Problem bei derartig hergestellten Schaltungsanordnungen besteht darin, dass die Etiketten an der Kasse eines Geschäftes, das Waren mit derartigen Etiketten führt, durch einen Stromstoss deaktiviert werden müssen. Dieser Stromstoss ist umso grösser, je dicker die Isolierschicht ausgebildet ist. Natürlich besteht das gleiche Problem bei Schaltungsanordnungen für verschiedene Sicherheits- und Ueberwachungszwecke, bei denen beispielsweise zwei durch ein Dielektrikum normalerweise voneinander getrennte Leiter im Alarmfalle durch einen Stromstoss überbrückt werden sollen. Die üblicherweise verwendeten Polyäthylenfolien (als Trägermaterial) können porenfrei nur bis etwa 30 Micrometer ausgewalzt werden, was zur Deaktivierung einer Resonanzetikette einen Stromstoss von etwa der zehnfachen Stärke gegenüber der zur Schwingkreisaktivierung nötigen Stromstärke bedingt. Diese Stromstärke erhöht sich selbstverständlich, wenn gar eine doppelte Lage an Trägermaterial vorgesehen werden soll und bedingt u.a. einen höheren Schaltungsaufwand.

Durch die Erfindung soll eine grössere Flexibilität in der Gestaltung und hinsichtlich der Dimensionen der Isolierschicht erreicht werden, und dies gelingt durch die Merkmale des Kennzeichens des Anspruches 1. Bevorzugte Auführungsformen des erfindungsgemässen Verfahren sind in den Kennzeichen der Ansprüche 2 bis 10 beschrieben. Besonders zweckmässig ist die Herstellung der Schaltungsanordnung nach dem Kennzeichen des Anspruches 8, bevorzugt nach wenigstens einem der Kennzeichen der Ansprüche 9 und 10.

Dabei ist es wesentlich, dass man bisher überwiegend der Meinung war, man müsse die Isolierschicht als Trägerschicht verwenden und die beiden Flächenabschnitte eines Schaltungsmusters auf je einer Seite dieser Trägerschicht aufbringen. Erfindungsgemäss wurden jedoch die Vorteile der beschriebenen Vorgangsweise erkannt, bei der eine Trägerfolie nur die Funktion hat, dass das Schaltungsmuster überhaupt hantierbar ist, während die Isolierschicht in bisher nicht bekannter Weise und aus bisher nicht bekanntem Material aufgebracht wird. Dabei ergibt die Verwendung eines Klebers, als Isolierschicht einen weiteren Vorteil: Um nämlich die Flächenabschnitte der Schaltung untereinander, bzw. mit dem Isoliermaterial zu verbinden, war bisher im allgemeinen eine Vorbehandlung nötig, falls eine Aluminiumschicht mit einem Kunststoff, wie Polyäthylen, verbunden werden sollte. Diese Vorbehandlung kann nun unterbleiben, so dass sich eine weitere Ersparnis ergibt. Bei der Herstellung von Leiterbahnen ist das Arbeiten mit ätzmittelbeständigem Lack (Lösungsmittel!) insofern weniger günstig, als die Komponentendichte immer grösser wird und so die Leiterbahnen immer näher aneinanderrücken, so dass (unter anderem wegen der Verdunstung des Lösungsmittels) die gewünschte Genauigkeit nicht mehr sicher gewährleistet ist. Dabei kann die Isolierschicht zu einem Bindemittel aktiviert werden, d.h. dass sie einen inaktiven Zustand ohne adhäsive Eigenschaften und einen aktiven Zustand mit solchen Eigenschaften besitzt.

Dadurch, dass ein Beschichtungsvorgang im flüssigen, bzw. pastösen Zustand des Isoliermaterials vorgenommen wird, hat man es in der Hand, sowohl die Dicke der Schicht nach Belieben zu wählen, als auch gegebenenfalls das Muster dieser Schicht willkürlich zu verändern. Damit aber ist auch eine genaue Einstellbarkeit gegeben. Bisher ergaben sich auf Grund von unvermeidlichen Dickenschwankungen der Isolierschicht auch unvermeidliche Frequenzabweichungen, so dass man in der Praxis statt mit einer bestimmten Frequenz jeweils mit einem ganzen Frequenzbereich arbeiten musste. Die Anwendung eines solchen Verfahrens ergibt sich in erster Linie für gedruckte Schaltungen, eignet sich aber auch für Hybridschaltungen. Der zweite Flächenabschnitt kann an sich gesondert hergestellt werden, könnte aber auch neben dem ersten auf demselben Trägermaterial vorgesehen und dann durch Falten desselben auf den ersten Flächenabschnitt darübergeklappt werden, wie dies in der eingangs genannten Druckschrift WO-A-82/00541 beschrieben ist, so dass die beiden Flächenabschnitte des Schaltungsmusters einander zugekehrt und nur durch die durch Beschichten aufgebrachte Isolationsschicht voneinander getrennt sind. Die Trägerfolie dient somit nur zur Stabilisierung des darauf befindlichen Leitungsmusters und kann an sich

EP 0 255 073 B1

eine beliebige Stärke besitzen, gewünschtenfalls auch dünner als die elektrisch leitende Schicht des Schaltungsmusters sein.

Es ist an sich nicht unbedingt erforderlich, dass der zweite Flächenabschnitt des Schaltungsmusters ebenfalls auf einem Trägermaterial vorgesehen wird, obwohl dies bevorzugt ist. An sich wäre es aber auch denkbar, den zweiten Flächenabschnitt z.B. in einem Druckvorgang auf die Isolationsbeschichtung aufzubringen.

Eine besonders vorteilhafte Ausführungsform kennzeichnet sich durch die Mermale des Anspruches 10. Dadurch ist auf besonders einfache Weise ein Abgleich des Kondensators zur Einstellung auf eine gewünschte Kapazität, bzw. (im Falle eines Schwingkreises, bzw. einer Resonanzetikette) auf eine gewünschte Frequenz möglich. Dieses Problem hat man nämlich bereits auf verschiedene Weise zu lösen versucht. Gemäss US-A-3 688 361 sollte eine zusätzliche Lage aus einer Isolierschicht und mehreren kleinen Kondensatorstreifen vorgesehen werden, die bei ungenügender Kapazität (die bei einem Kontrollvorgang festgestellt wurde) zugeschaltet werden konnten. Die zusätzliche Lage bedeutet aber einen weiteren Aufwand, und es lässt sich überhaupt feststellen, dass der in dieser Druckschrift vorgeschlagene Aufbau sehr dick auftrug.

Daher wurde in der US-A-4 021 705 vorgeschlagen, den Abgleich nicht am Kondensator, sondern am Induktor durch Durchschmelzen einzelner Windungsabschnitte vorzunehmen.

Eine solche Vorgangsweise ist aber fehleranfällig und lässt im übrigen einen Abgleich - ebenso wie die Methode nach der US-A-3688 361 - nur in groben Abstufungen zu. Dagegen lässt das Verfahren nach Anspruch 10 einen stufenlosen Abgleich zu, so dass die gewünschte Frequenz auf das genaueste eingestellt werden kann. Prinzipiell ist dieses Verfahren nicht einmal an das Aufbringen der Isolierschicht in flüssigem oder pastösem Zustand gebunden, da es bei jeder nachträglich, insbesondere unter Wärmeeinwirkung, verformbaren Isolierschicht anwendbar ist. Das Verfahren wird zweckmässig am Ende der Herstellung unter gleichzeitiger Messung des jeweils gewünschten Wertes (Kapazität, bzw. Frequenz) vorgenommen, wobei das Werkzeug über eine Komparatorstufe zum Vergleich von Soll- und Istwert zweckmässig automatisch bis zur Erreichung einer Null-Differenz angedrückt wird. Eine Absenkung des Werkzeuges auf eine voreingestellte Position wird nämlich im allgemeinen deshalb nicht den gewünschten Frequenz- bzw. Kapazitätswert liefern, weil Ungleichmässigkeiten des Isoliermaterials und Toleranzen in der elektrisch leitenden Schicht Abweichungen ergeben können.

Zur Verringerung der Kondensatorgrösse und damit der Gesamtabmessungen und/oder zur Verminderung der nötigen Stromstärke bei Resonanzetiketten sind dabei die erfindungsgemässen Merkmale vorgesehen. Wenn dabei die Isolerschicht vorzugsweise dünner als die Trägerfolie ist, so ist es zweckmässig, wenn sie um wenigstens 10% dünner ausgebildet ist.

Weitere Einzelheiten ergeben sich an Hand der nachfolgenden Beschreibung von in der Zeichnung schematisch dargestellten Ausführungsbeispielen. Es zeigen:

Fig. 1     eine Draufsicht auf die Fläche einer Resonanzetikette in explodierter Darstellung;

Fig. 2     einen Schnitt nach der Linie II-II der Fig. 1 durch den unteren Flächenabschnitt einer solchen Resonanzetikette;

Fig. 3     ein späteres Stadium bei der Herstellung der Schaltungsanordnung in einem der Fig. 2 analogen Schnitt;

Fig. 4     einen der Fig. 3 ähnlichen Schnitt, jedoch durch die Kontakt-Enden der beiden Flächenabschnitte der Schaltungsanordnung während des Verkrimpens; und

Fig. 5     einen weiteren der Fig. 3 ähnlichen Schnitt zur Veranschaulichung der Herstellung einer Resonanzetikette mit nur einer Trägerfolie mit Hilfe eines Stanzvorganges; und

Fig. 6     eine Draufsicht auf eine andere Ausführung, an Hand derselben eine Berechnung erläutert wird.

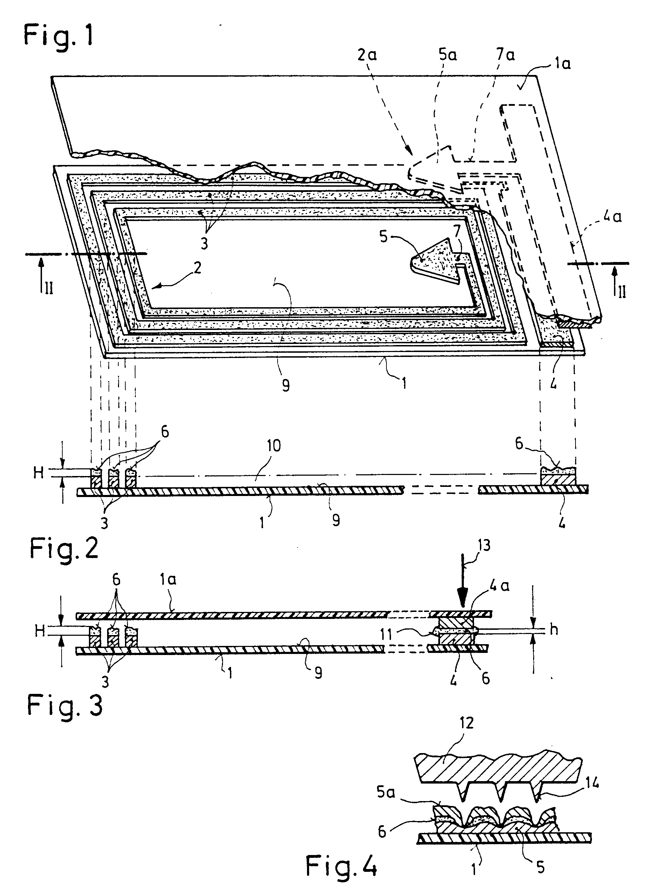

Fig. 1 zeigt ein isolierendes Trägermaterial 1, auf das ein erster Flächenabschnitt 2 eines elektrisch leitenden Schaltungsmusters, beispielsweise durch Drucken oder durch Heissiegeln, aufgebracht ist. Der Flächenabschnitt 2 weist einen spiralartig geformten Induktor 3 und an dessen einem Ende die Platte 4 eines Kondensators auf, der - nach dem Aufbringen eines Dielektrikums - eine entsprechende Platte 4a eines zweiten Flächenabschnittes 2a gegenübergelegt wird.

Das Trägermaterial 1 ist zweckmässig bandförmig ausgebildet, um eine Anzahl von solchen Flächenabschnitten nebeneinander aufzunehmen. Jeder dieser Flächenabschnitte 2 besitzt ein Kontaktstreifen-Ende 5, das mit einem entsprechenden Ende 5a des jeweiligen zweiten Flächenabschnittes durch Einprägen mittels eines Zähne aufweisenden Stempels "verkrimpt", d.h. also in Kontakt gebracht wird, wie an Hand der Fig. 4 noch erläutert wird. Induktor 3 und Kondensator 4 stellen dann einen Schwingkreis dar, wie er für Resonanzetiketten verwendet wird.

3

Der zweite Flächenabschnitt 2a der Schaltungsanordnung umfasst praktisch nur die erforderliche zweite Kondensatorplatte 4a, die ebenfalls durch Drucken oder durch Aufdampfen auf eine Trägerfolie 1a aufgebracht sein kann, sowie einen daran anschliesenden Verbindungsabschnitt 7a, der einem analogen Verbindungsabschnitt 7 des Flächenabschnittes 2, bzw. des Induktors 3 entspricht und ebenfalls zu einem Kontaktstreifen-Ende führt, das in Fig. 4 im Schnitt zu sehen und analog zum Kontaktstreifen 5 ausgebildet ist.

Selbstverständlich ist die Erfindung nicht auf die Verwendung von nur zwei Flächenabschnitten beschränkt, vielmehr könnten, etwa in der Art der Anordnung nach der US-A-3 688 361, auch mehr als zwei Flächenabschnitte vorgesehen sein. Ferner ist es nicht erforderlich, dass eine zweite Trägerfolie 1a vorgesehen wird, obwohl dies bei der Herstellung und anschliessend auch im Gebrauch (als Schutz) von Vorteil sein wird.

Die vorstehend beschriebenen Teile sind an sich bekannt. An Hand der Fig. 2 bis 4 soll nun ein Ausführungsbeispiel für die Herstellung einer Schaltungsanordnung erfindungsgemässer Resonanzetiketten besprochen werden. Dabei sind dieses Verfahren und die Schaltungansordung nicht auf Resonanzkreise beschränkt, sondern können an sich beliebige Schaltkreise in gedruckter oder in Hybridtechnik betreffen, beispielsweise auch die Schaltkreise eines Rundfunkempfängers, Funksignalgebers (z.B. zur Abgabe eines Alarmsignales beim Defektwerden einer Rohrleitung) oder für Spielzeug (z.B. fernlenkbare Modelle). Eine derartige Schaltungsanordnung kann dann auf eine Wand des jeweiligen Gerätes beispielsweise aufgeklebt werden, statt durch Schrauben befestigt zu sein.

Im Schnitt nach Fig. 2 ist ersichtlich, dass auf Induktor 3 und Kondensatorplatte 4 jeweils eine Isolierschicht 6 aufgetragen ist, die im Falle des Kondensators 4, 4a als Dielektrikum dient.

Nach der Darstellung der Fig. 2 ist die Trägerfolie 1 vorzugsweise verhältnismässig dünn im Vergleich zur Dicke der elektrisch leitenden Schicht des Schaltungsmusters 2. Dies ist aber keineswegs Bedingung, vielmehr kann die Stärke dieser beiden Schichten 1, 2 an sich beliebig gewählt werden. Für Resonanzetiketten wird das Schaltungsmuster 2 beispielsweise aus einer Aluminiumschicht von maximal 50 $\mu$m (micron) und das Trägermaterial aus einer Polyäthylen-, bevorzugt aber aus einer Polyesterfolie bestehen. Die Stärke dieser Folie beträgt z.B. maximal 30 $\mu$m (30 micron), im Falle der Polysterfolie gegebenenfalls nur 10 $\mu$m (10 micron) oder weniger.

Die Verbindung der beiden Schichten 1, 2 miteinander kann in an sich bekannter Weise erfolgen. Beispielsweise ist das Schaltungsmuster 2 im Falle der Fig. 2 bereits in der aus Fig. 1 ersichtlichen Form aufgedruckt. Darüber kommt nun die Dielektrikumschicht 6, die im plastischen, d.h. verformbaren Zustand desselben, also als Flüssigkeit bzw. Paste aufgetragen wird. Dieser Beschichtungsvorgang kann in beliebiger, für andere Beschichtungsvorgänge bekannter Weise erfolgen, insbesondere durch Bedrucken. Durch die Verformbarkeit und durch diese Art der Aufbringung kann die Schichtdicke der Isolierschicht 6 relativ einfach kontrolliert und vor allem auch relativ dünn gehalten werden, nämlich dünner als dies bisher möglich war.

Um eine gute Verbindung der Isolierschicht mit dem ersten Flächenabschnitt 2 des Schaltungsmusters einerseits, und mit dem zugehörigen zweiten Flächenabschnitten 2a des Schaltungsmusters zu sichern, besteht die Isolierschicht 6 vorzugsweise aus einem Kleber (im weiteren Sinne). In einem einfachen Falle kann es sich dabei um einen durch Druck aktivierbaren Kleber handeln, doch wird es gerade bei Kondensatoren bzw. den in Resonanzetiketten vorgesehenen Schwingkreisen wegen der Einhaltung einer vorbestimmten Stärke des Dielektrikums vorteilhaft sein, entweder einen Heissschmelzkleber (von im allgemeinen wenigstens 10 $\mu$m) zu verwenden oder - was besonders bevorzugt ist - einen Heissiegellack. Derartige Lacke, z.B. auf Basis Vinyl-Acryl, liegen im allgemeinen in einer Emulsion in einem Lösungsmittel vor, das man nach dem Auftragen der Schicht verdampfen lässt. Es können so extrem dünne Schichten von etwa 3 bis 4 $\mu$m erhalten werden. Damit genügen (im Falle einer Resonanzetikette) zur Deaktivierung der Schaltung Stromstösse von nur der doppelten Stärke, die für die Schwingkreisaktivierung erforderlich ist.

Weitere Vorteile einer so erzielten extrem dünnen Dielektrikumschicht liegen darin, dass der Kondensator hinsichtlich seiner Fläche kleiner sein kann, wodurch einerseits die Gesamtfläche der Etikette verringert, andererseits die innerhalb der Spirale des Induktors 3 freibleibende Fläche 9 vergrössert wird. Diese Fläche 9 wird vom Magnetfeld des Induktors durchdrungen. Das dabei erhaltene Signal wird daher um bis zu 30 % stärker. Die Fläche 9 kann aber noch weiter vergrössert (oder gewünschtenfalls für weitere Induktorwindungen genutzt) werden, wenn, wie aus Fig. 1 ersichtlich, die Kondensatorplatte 4 - abweichend vom Herkömmlichen - ausserhalb der Spirale des Induktors 3 angeordnet wird, wogegen die Kontaktfelder 5,5a innerhalb des Induktors 3 liegen. Es hat sich gezeigt, dass dies noch weitere Vorteile erbringt: Durch das im Bereich der freien Fläche 9 erzeugte Magnetfeld kommt es nämlich zur Ausbildung von Wirbelströmen in der Kondensatorplatte 4, wenn diese in üblicher Weise innerhalb der Spirale des Induktors 3 angeordnet

EP 0 255 073 B1

wird. Dies führt zur Notwendigkeit, die Kondensatorplatte 4 grösser zu bemessen, als dies an sich erforderlich wäre. Durch die Anordnung der Kondensatorplatte 4 ausserhalb des Induktors 3 kann also eine weitere Miniaturisierung eines derartigen Schaltkreises, bzw. der Resonanzetikette erzielt werden.

Sobald die Isolierbeschichtung aufgebracht ist, kann auch der zweite Flächenabschnitt 2a aufgebracht werden. Bloss aus Stabilisierungsgründen kann dieser zweite Flächenanschnitt 2a des Schaltungsmusters auf einer Trägerfolie 1a aufgebracht, beispielsweise auch aufgedampft, sein. Diese Trägerfolie 1a kann aber auch lediglich die Fortsetzung der Folie 1 darstellen, wobei die beiden Flächenabschnitte 2, 2a beispielsweise nebeneinander vorliegen und die Trägerfolie 1, bzw. 1a so gefaltet wird, dass sie in eine Lage nach Fig. 1 kommt. Hiezu kann eine schwächere Sollfaltstelle (nicht dargestellt) entweder bereits von vorne herein in dem Trägermaterial 1, bzw. 1a vorgesehen sein oder erst nach dem Aufbringen des elektrisch leitenden Schaltungsmusters 2, bzw. 2a erzeugt werden.

Es ist jedoch nicht unbedingt erforderlich, den zweiten Flächenabschnitt 2a des Schaltungsmusters auf einem Trägermaterial 1a vorzusehen, vielmehr könnte dieser Flächenabschnitt 2a gegebenenfalls auch unmittelbar auf die Isolierschicht 6 aufgebracht werden, z.B. durch Aufdrukken oder Aufdampfen. Ein solches Vorgehen wird besonders dann zweckmässig sein, wenn mehr als zwei Flächenabschnitte 2, 2a übereinander aufgebracht werden sollen. Eine andere Möglichkeit besteht darin, den zweiten Flächenabschnitt 2a nach Art eines Abziehbildes zunächst auf einem Trägermaterial aufzubringen, z.B. durch Aufdampfen, und dann - nach dem Uebereinanderlegen der Flächenabschnitte 2, 2a - die Trägerfolie 1a wieder abzuziehen.

In vielen Fällen, besonders etwa bei der Anwendung auf Leckdetektoren, wird es aber sogar vorteilhaft sein, wenn die zweite Trägerfolie 1a mit dem Schaltkreis verbunden bleibt, und in diesem Falle können die beiden Trägerfolien 1, 1a, am Rande entweder miteinander heissversiegelt werden, oder es wird einfach die Kleberschicht 6 auch über die Randbereiche der Trägerfolie 1 aufgebracht, wo sie zum Verkleben der beiden Trägerfolien 1, 1a dient.

Es wurde bereits erwähnt, dass durch das Aufbringen der Isolierschicht 6 im verformbaren Zustand nicht nur deren Dicke leichter und auf extrem dünne Masse einstellbar ist, sondern dass damit auch das Beschichtungsmuster bestimmt werden kann. An sich könnte die Isolierschicht im wesentlichen durchgehend ausgebildet und das Schaltungsmuster 2, bzw. 2a bereits fest aufgedruckt sein. Auch könnte die Isolierschicht im Bereich zweier Flächenabschnitte der leitenden Schicht eine Unterbrechung aufweisen, um einen Kontakt dieser Flächenabschnitte zu gewährleisten, bzw. um einen Bauteil grösserer Stärke, z.B. einen Widerstand zu bilden.

Günstiger ist aber in dieser Hinsicht eine Ausbildung, bei der auf das Trägermaterial 1 (dieses muss nicht eine Kunststoffolie sein, es könnte sich auch um eine Siliziumscheibe handeln) in an sich bekannter Weise zunächst eine durchgehende elektrisch leitende Schicht aufgebracht ist. Auf diese wird dann die Isolierschicht in Form des Schaltungsmusters gemäss Fig. 1 aufgebracht. Diese Isolierschicht wird wiederum zweckmässig von einem Kleber gebildet, der aber hier eine zusätzliche Eigenschaft besitzen soll, nämlich ätzmittelbeständig zu sein. Beispiele für einen derartigen Kleber sind die von der Firma Henkel unter dem Warenzeichen "Technomelt Q 2375" oder "Q 2279" vertriebenen Schmelzklebstoffe. Obwohl durch Lösungsmittel aktivierbare Kleber (wegen etwaiger Blasenbildung und der Notwendigkeit der Absaugung der Lösungsmitteldämpfe) im allgemeinen nicht bevorzugt sind, könnte als ätzmittelbeständiger Kleber auch z.B. das unter dem entsprechenden Warenzeichen vertriebene LIOFOL UK 3640 in Frage kommen der zusammen mit dem Härter UK 6000 einen Zwei-Komponenten-Kleber bildet.

Wie Fig. 2 zeigt, liegt die Dicke der Isolierbeschichtung zunächst innerhalb eines gewissen Toleranzbereiches, was durch eine Welligkeit der Oberfläche dieser Beschichtung angedeutet ist. Dabei wird die Schichtdicke so bemessen, dass sich Toleranzen nur oberhalb eines gewünschten Sollwertes ergeben. Dementprechend ergibt sich eine Schichtdicke H. Um eine genau bemessene Dicke des Dielektrikums zu erhalten und so den Kondensator 4 (Fig. 1) auf einen genauen Wert einzustellen (was bisher nicht ohne weiteres möglich war), wird nach der Herstellung in einem Kontrollvorgang Messung der Resonanzfrequenz die Solldicke h (Fig. 3) eingestellt, beispielsweise durch Zusammenpressen mittels eines Heissstempels (Pfeil 13). Auch (z.B. beheizte) Walzen oder Schaben wären möglich, obwohl letztere seltener angewendet werden.

Bevor es aber soweit ist, werden (im Zustand nach Fig. 2) die Bereiche 10 der leitenden Schicht weggeätzt, und zu diesem Zwecke wird eben der ätzmittelbeständige Kleber benötigt. Es bleiben sodann die den einen Flächenabschnitt 2 des Schaltungsmusters bildenden Bereiche mit den Teilen 3 und 4 übrig. Ein solches Vorgehen erspart nicht nur Material, sondern vereinfacht auch die Herstellung, da so der Kleber eine mehrfache Funktion erfüllt. Wenn die Kleberschicht 6 erst nach dem Aetzen auf die Soll-Dicke h gebracht wird und sich dadurch leicht über die Flächenbereiche 2 überstehende Ränder 11 (Fig. 3) ergeben, so beeinflusst dies nicht mehr das Flächenmass, das ja besonders im Falle eines Kondensators 4

5

- falls sehr exakt bemessen werden muss.

Nach dem Aufbringen des zweiten Flächenabschnittes 2a (Fig. 1) auf den entsprechenden Fig. 2 behandelten Flächenabschnitt 2 der Schaltungsanordnung, und vor dem an Hand der Fig. 3 beschriebenen Kontrollvorgang, werden die Kontaktstreifen-Enden 5, 5a miteinander verkrimpt. Dies geschieht gemäss Fig. 4 mit einem Zacken 14 aufweisenden Heissstempel 12, wobei die zahlreichen, nebeneinander liegenden Zacken 14 für einen guten Kontakt der beiden Teile 5, 5a miteinander sorgen.

Es sei darauf hingewiesen, dass der Vorgang des sogenannten "Krimpens" nach bekannten Vorschlägen (EP-A-142 380) durch blosses Verquetschen erfolgt. Wird aber etwa erfindungsgemäss ein Heisssigellack als Schicht 6 verwendet, so kann dieser z.B. durch Ultraschall geschmolzen, sodann mit Hilfe eines - gegebenenfalls erhitzten - Stempels verformt und mit dem Abheben des Stempels auch wieder abgekühlt werden. Auf diese Weise entsteht eine nicht nur mechanische, unter Umständen bei der praktischen Anwendung durch Walken leicht lösbare Verbindung, die bei bekannten Verfahren immer wieder zu Ausschuss führte, sondern eine durch Klebung chemisch unterstützte Verbindung.

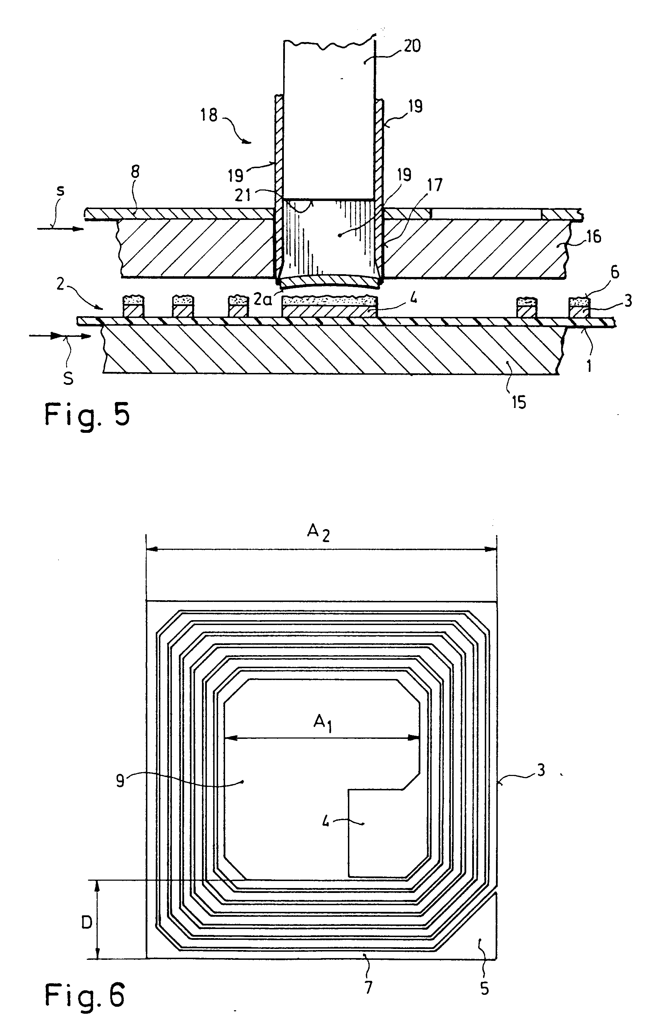

Wie bereits erwähnt, ist es nicht erforderlich, dass beide Flächenabschnitte 2, bzw. 2a des Schaltungsmusters auf einem Trägermaterial aufgebracht sind. Wenigstens ein Flächenabschnitt, z.B. 2a, kann ohne Trägerfolie aufgebracht werden, etwa wie dies Fig. 5 veranschaulicht. Dabei wird die Trägerfolie 1 mit dem Flächenabschnitt 2 und der Kleberschicht 6, die entsprechend Fig. 2 in der Höhe H aufgetragen ist, schrittweise mit einer Schrittgrösse S (siehe Pfeil) auf einer Unterlage 15 bewegt.

Parallel dazu ist ein Stanzgitter 16 angeordnet, das wenigstens eine Oeffnung 17 für den Durchtritt eines Stanzstempels 18 aufweist. Dieses Stanzwerkzeug 18 hat in Druntersicht die Form des Flächenabschnittes 2a (vgl. Fig. 1) und besteht aus einem Schneidewerkzeug 19 und einem Stempel 20. Beide Werkzeuge 19,20 sind unabhängig voneinander, nach einem vorgegebenen Bewegungsprogramm (d.h. im allgemeinen mechanisch miteinander gekoppelt) betätigbar. Selbstverständlich ist es durchaus möglich, mehrere solcher Stanzwerkzeuge 18 jeweils für parallel laufende Trägerfolien 1 oder auch hintereinander in einem einer Resonanzetikette entsprechenden Abstand (oder einem Vielfachen davon) vorzusehen.

Auf dem Stanzgitter 16 läuft ein Band 8, aus dem mittels des Stanzwerkzeuges 18 der Flächenabschnitt 2a ausgestanzt und in der noch zu beschreibenden Weise auf den Flächenabschnitt 2 aufgebracht wird. Um an Material zu sparen (bei einem Aetzvorgang, wie er oben beschrieben wurde, gehen bis zu 80% des Leitermaterials verloren), kann das Band 8 aus elektrisch leitendem Material, z.B. aus Aluminium, mit einer geringeren Schrittgrösse s (siehe Pfeil) über das Stanzgitter 16 bewegt werden. Die Bewegung der Folie 1 ist nun aber mit der des Stanzwerkzeuges 18 derart synchronisiert, dass sich das Schneidewerkzeug 19 erst dann aus einer gegenüber Fig. 5 angehobenen Lage oberhalb des Bandes 8 abwärts bewegt, wenn sich die Kondensatorplatte 4, bzw. auch das (aus Fig. 5 nicht ersichtliche) Kontaktende 5 genau unter der Oeffnung 17 des Stanzgitters 16 befindet, wobei die Oeffnung 17 selbstverständlich ebenfalls die Form des Flächenabschnittes 2a (Fig. 1) aufweist. Daher wird das Band 8 durch Scherwirkung des Schneidewerkzeuges 19 entlang der Kanten der Oeffnung 17 durchtrennt, wobei der ausgestanzte Flächenabschnitt 2a vom unteren Ende des Schneidwerkzeuges 19 im allgemeinen gehalten wird, allenfalls aber auch sofort auf die Klebstoffschicht 6 des Flächenabschnittes 2 fällt.

Nun senkt sich der, z.B. beheizte, Stempel 20 ab. Gegebenenfalls kann zur Erhitzung Ultraschall angewandt werden. Der Stempel 20 drückt dann mit seiner Unterfläche 21 den durch das Schneidewerkzeug 19 genau in seiner Lage gehaltenen Flächenabschnitt 21 auf die Klebeschicht 6, an der der Flächenabschnitt 2a in jedem Falle haften bleibt. Das Mass des Druckes des Stempels 20 bestimmt die zwischen den Flächenabschnitten 2,2a als Dielektrikum verbleibende Schichtdicke des Klebers 6, wobei bereits erwähnt wurde, dass es günstig ist, diese Schichtdicke mit einer positiven Toleranz zu versehen, die erst in einem nachfolgenden Kontrollvorgang mit Hilfe eines ähnlichen Stempels, aber bei gleichzeitiger Messung genau abgestimmt wird. Aus der obigen Erläuterung ist ersichtlich, dass man auf diese Weise beliebige Schichtdicken des Dielektriums 6 erhalten kann, wodurch sich jeweils gewünschte Frequenzen des so geschaffenen Schwingkreises ergeben. Es ist also möglich, ohne Aenderung des Schaltungsmusters 2, bzw. 2a Schwingkreise beliebig gewünschter Frequenz zu erhalten, was eine weitere Einsparung ergibt. Dazu kommt noch die schon erwähnte Materialersparnis, die noch erhöht werden kann, wenn sich die auszustanzenden Flächenabschnitte als dünne, allein nicht hantierbare, eventuell aufgedampfte Schicht an der Unterseite eines (in Fig. 5 nicht dargestellten) Trägerbandes (entsprechend dem Trägermaterial 2a im Fig. 1) befinden.

Es sei erwähnt, dass die Herstellung von Schwingkreisen unterschiedlicher Frequenz unter Beibehaltung des Schaltungsmusters nicht unbedingt an die Verwendung eines flüssig, bzw. in pastösem Zustand aufgebrachten Dielektrikums gebunden ist, denn es wäre ja an sich möglich, als Dielektrikum ein in der Wärme (oder sonstiger Einwirkung) verformbares Material, z.B. einen Thermoplasten, zu verwenden, der dann, zweckmässig während des Kontrollvorganges, auf das jeweils gewünschte Mass zusammengepresst wird. Durch die Verwendung eines flüssig-pastösen Mittels und insbesondere eines Klebers lässt sich aber dieser Vorgang leichter beherrschen, wobei jedenfalls auch nachträgliche Veränderungen auf Grund einer Restelastizität ausgeschlossen sind.

Das Stanzen, wie dies beispielshalber oben beschrieben wurde, ist auch schon an sich ein wesentlich billigeres Herstellverfahren als etwa Aetzen mittels einer erst aufgebrachten Fotoresistfolie, teilweiser Vernetzung durch Belichtung, Weglösen der unbelichteten Teile, Wegätzen des darunterliegenden Aluminiums und anschliessenden Abschleifen der noch verbliebenen Fotoresistfolie.

Vorzugsweise wird der Kleber mittels Siebdruck, Tampondruck oder Rotogravur aufgebracht, wobei eine hohe Genauigkeit des Linienverlaufes erzielt werden kann, wogegen bei ungenauem Arbeiten sich sog. "Flaschenhälse" ergeben können, wenn zu beiden Seiten einer Leiterbahn Verengungen auftreten.

Im Rahmen der Erfindung sind zahlreiche Varianten möglich; beispielsweise könnte eine Isolierfolie durch Erhitzen oder durch ein Lösungsmittel in einen verformbaren, bzw. plastischen Zustand gebracht und als Isolierschicht 6 verwendet werden, wobei man die Folie durch Druck auf die Soll-Dicke bringt. Es sei jedoch erwähnt, dass die Verwendung eines Klebers schon deshalb bevorzugt ist, weil ein solcher schon an sich eine wesentlich geringere Dielektrizitätskonstante besitzt. Es ist deshalb bevorzugt, als Beschichtung ein Material mit einer Dielektrizitätskonstante von maximal 3,0 zu verwenden (zum Vergleich: Polyester besitzt eine Konstante von 3,6 wogegen ein typischer Heissiegellack eine solche von nur 2,3 aufweist). Auch versteht es sich, dass die Kontaktstreifen-Enden 5,5a an sich beliebige Form haben können, also nicht unbedingt dreieckig sein müssen.

Soll das Trägermaterial 1a nach dem Aufbringen des zweiten Flächenabschnittes 2a des Schaltungsmusters wieder entfernt werden, so muss dies nicht unbedingt durch Abziehen nach Art eines Abziehbildes geschehen, vielmehr wäre beispielsweise auch einfach eine chemisch/ physikalische Ablösung möglich. Zu diesem Zwecke kann das Trägermaterial 1a beispielsweise aus Alginat bestehen (in Seifenwasser löslich) oder aus einem niederschmelzbaren Material.

Zur Erläuterung der Erfindung soll nun noch ein Berechnungsbeispiel gegeben werden.

Ziel muss es bei einem Schwingkreis sein, ein grösstmögliches Signal (Q-Faktor, Güte der Spule) bei möglichst kleiner Fläche zu erreichen. Dies ist nun an sich eine in sich widersprüchliche Forderung, denn das Signal wird umso grösser sein, je grösser die Induktorspule 3 und die dazwischen frei bleibende Fläche 9 ist. Anderseits ist es nötig, schon aus Gründen der Produktionskosten (Material, bzw. Stückzahl/Zeiteinheit), aber auch, um ein möglichst umfangreiches Einsatzgebiet der zu fertigenden Sicherheits-(Resonanz-) Etikette zu erhalten, eine möglichst kleine Fläche vorzusehen.

Nun ergibt sich die Induktivität L aus der Formel

$$L = \frac{A.A \times N.N}{2.54 \ (8xA + 11xD)} \qquad (1)$$

wobei

N  die Anzahl der Windungen des Induktors 3,
D  die radiale Tiefe der Windungen (vgl. Fig.6) und
A  der durchschnittliche Radius derselben ist.

Der durchschnittliche Radius ergibt sich gemäss Fig. 6 in cm aus der Formel

$$\frac{A1 + A2}{4} \quad 1.2 \qquad (2)$$

In Formel (1) wird allerdings das erregende Magnetfeld nicht berücksichtigt, wogegen die Grösse der freien Fläche 9 indirekt durch die Abhängigkeit von D und A Berücksichtigung findet. Dagegen ist in dieser Formel (1) auch weder die Dicke des Materials, noch der Zwischenraum der leitenden Bahnen zueinander

7

enthalten, die ebenfalls von Bedeutung sind, so dass Formel (1) nur eine Näherungsformel darstellt.

Betrachtet man die Frequenz des zu erzeugenden Schwingkreises, so ergibt sich diese aus der Formel

$$f = \frac{1}{2 \cdot \pi \cdot \sqrt{L \cdot C}} \qquad (3)$$

worin

L    die Induktivität und

C    die Kapazität des Kondensators in pikofarad ist.

In Formel (3) kann die Kapazität C aus folgender Formel abgeleitet werden:

$$C = \frac{A \cdot K \cdot N}{11,3 \times t} \qquad (4)$$

worin

A    die Fläche des Kondensators in cm2

K    die dielektrische Konstante

N    die Anzahl der Lagen (Flächen 4,4a und allfällige weitere zugehörige Flächenbereiche) von Kondensatoren ist, die untereinander verbunden sind,

t    die Dicke des Dielektrikums in cm, und

N    eine Konstante von beispielsweise 1 ist.

Wenn daher für einen praktischen Anwendungsfall in Fig. 6 A1 2,7 cm beträgt und A2 4,7 cm, so ergibt sich aus der Formel (2) ein durchschnittlicher Radius von 2,22 cm.

Es sei nun weiter angenommen, dass D = 1 und L = 3,306, wobei die Frequenz f 8,2 MHz betragen soll. Dabei ergibt sich nach Formel (3) eine erforderliche Kapazität C von 113,8 pF. Für einen derartigen Kondensator wird nach Formel (4), bzw. nach deren Umwandlung zur Errechnung von A eine erforderliche Fläche von 0,64 cm2 ergeben, wenn angenommen wird, dass die Dicke t 10 $\mu$m (0,001 cm) beträgt und K im Falle der Verwendung von Heissiegellackes 2 beträgt. Dies bedeutet gegenüber der herkönnlichen Verwendung von Polyäthylen, das nicht dünner als mit 30 $\mu$m hergestellt werden kann und eine Dielektrizitätskonstant K von 2,3 besitzt (woraus sich eine Fläche A von 1,677 $cm^2$ ergibt), dass man erfindungsgemäss mit rund dem 2,5. Teil der Fläche des Kondensators in bekannten Resonanzetiketten auskommt (genauer gesagt ist die Fläche herkömmlich rund 2,6 mal so gross, wobei die freie Fläche 9 dadurch um etwa 1 $cm^2$ reduziert wird).

Vergleicht man nun bei einem deartigen Unterschied der Kondensatorgrösse due verbleibende freie Fläche 9, so ergibt sich bei einer von den Induktorwicklungen 3 eingeschlossenen Gesamtfläche von beispielsweise 2,7 mal 2,7cm (= 7,29 $cm^2$) abzüglich der benötigten Kondensatorfläche bei erfindungsgmässer Ausbildung eine freie Fläche 9 von 6,65 $cm^2$, bei herkömmlicher Ausbildung eine Fläche 9 von 5,61 $cm^2$. Dies bedeutet also eine Reduktion der fläche 9 um etwa 15,6% gegenüber der erfindungsgemässen Ausbildung, oder, aders ausgedrückt, nimmt der Kondensator bei erfindungsgemässer Ausbildung 8,8% der Fläche in diesem Beispiel ein, herkömmlicher Ausbildung sogar 23%!

Dabei ergibt dich aber wegen der günstigeren Bedingungen durch die erfindungsgemässe Ausbildung noch ein deutlicheres Signal und zusätzlich der Vorteil, dass die Resonanz-Etikette durch geringere Ströme deaktivierbar ist, was ebenfalls eine Schaltungsvereinfachung im entsprechenden Stromkreis mit sich bringt.

Mit einer mit den obigen Angaben hergestellten Resonanz-Etikette konnten jeweils gewünschte Resonanzfrequenzen nur durch Einstellung der Dicke t erhalten werden, ohne dass das Schaltungsmuster geändert werden musste. Es ergaben sich dabei die folgenden Zuordnungen von Frequenz f und Dicke t gemäss

| Tabelle 1: | Frequenz f | Dicke t (µm) |
|---|---|---|
| | in MHz | der Schicht 6 |
| | 8,2 | 10 |
| | 10,0 | 15 |
| | 11,0 | 18 |
| | 7,5 | 8,2 |

Selbstverständlich handelt es sich hier nur um einige Beispiele, und es sind sämtliche Zwischengrössen sowie beliebige andere Werte erhältlich, wobei jedesmal mit demselben Schaltungsmuster gearbeitet werden kann, was bisher nicht möglich war. Dies führt zu einer weiteren Reduktion der Kosten. Als Faustregel lässt sich feststellen, dass eine Aenderung der Frequenz um 10% einer Aenderung der Dicke t um 20% entspricht. Da diese Dicke t sehr genau einstellbar ist und überdies noch vorzugsweise der schon beschriebene Kontrollvorgang durch geführt wird, sind die Frequenzen mit äusserst engen Toleranzen einstellbar, wogengen herkömmliche Resonanzetiketten mit einer Frequenzbandbreite von etwa 20% arbeiten mussten.

Es sei erwähnt, dass das obige Berechnungsbeispiel nur zur Veranschaulichung dient, dass aber gegebenenfalls noch weit geringere Kondensatorflächen, bzw. Dicken t erzielbar sind, so dass die Kosten bei erhohter Genauigkeit der gewünschten Frequenz deutlich reduziert werden können.

**Patentansprüche**

1. Verfahren zum Herstellen einer Schaltungsanordnung, bei der ein erster, auf einem ersten Trägermaterial (1) befindlicher Flächenabschnitt (2) eines elektrisch leitenden Schaltungsmusters (3) wenigstens einen Flächenbereich (4) aufweist, der von einem Flächenbereich (4a) eines zweiten Flächenabschnitts (2a) - nur durch eine Isolierschicht (6) voneinander getrennt - überdeckt wird, und bei der die Isolierschicht (6) zwischen den beiden Flächenbereichen (4, 4a) höchstens gleich dick ist, wie das Trägermaterial (1), dadurch gekennzeichnet, dass zunächst auf den ersten Flächenabschnitt (2) in einem Beschichtungsvorgang die Isolierschicht (6) in Form eines Klebers in flüssigem oder pastösem Zustand aufgebracht wird, und dass dann auf diese, gegebenenfalls noch flüssige bzw. pastöse Isolierschicht (6) der zweite Flächenabschnitt (2a) des Schaltungsmusters aufgebracht wird.

2. Verfahren nach Anspruch 1, dadurch gekennzeichnet, dass als Kleber ein wärmeaktivierbares und/oder ätzmittelbeständiges Material, insbesondere ein Heissiegellack, verwendet wird.

3. Verfahren nach einem der Ansprüche 1 und 2, dadurch gekennzeichnet, dass die Isolierschicht (6) zwischen den beiden Flächenbereichen (4, 4a) wenigstens in einem Bereich nur auf das leitende Schaltungsmuster (3), nicht jedoch auf die dazwischenliegenden Abschnitte (10) aufgebracht wird.

4. Verfahren nach einem der Ansprüche 1 bis 3, dadurch gekennzeichnet, dass die Isolierschicht (6) in einer Stärke von maximal 20 Mikrometern, vorzugsweise von weniger als 15 Mikrometern, und insbesondere von zwischen 3 und 7 Mikrometern aufgebracht wird.

5. Verfahren nach einem der Ansprüche 1 bis 4, dadurch gekennzeichnet, dass die Schaltungsanordnung die Form einer Resonanzetikette mit einem Induktor und einem Kondensator aufweist, und dass die zwei einander überdeckenden, durch die Isolierschicht (6) getrennten Flächenabschnitte (2, 2a) den Kondensator bilden, wobei die Isolierschicht (6) vorzugsweise zwischen den Flächenbereichen (4, 4a) herausragende Wülste (11) aufweist.

6. Verfahren nach Anspruch 5, dadurch gekennzeichnet, dass zwei weitere einander überdeckende Flächenbereiche (5, 5a) mittels Verkrimpen durch die Isolierschicht (6) hindurch als Kontakte in elektrisch leitende Verbindung gebracht werden, wobei vorzugsweise die Isolierschicht (6) im Bereich der Kontakte Löcher (6') aufweist, entlang deren Rand die beiden Flächenbereiche (5, 5a) im wesentlichen ohne Unterbrechung miteinander verbunden sind.

**7.** Verfahren nach einem der Ansprüche 5 und 6, dadurch gekennzeichnet, dass eine Induktorspule (3) vorgesehen ist, und die innerhalb der Induktorspule (3) liegenden, einander überdeckenden Flächenbereiche (4, 4a bzw. 5, 5a) weniger als 40%, vorzugsweise weniger als 25 % der von der Induktorspule (3) umschlossenen Fläche (9) einnehmen.

**8.** Verfahren nach Anspruch 1, dadurch gekennzeichnet, dass der zweite Flächenabschnitt (2a) auf einem zweiten Trägermaterial (1a) angeordnet ist, dass das zweite Trägermaterial (1a) derart auf das erste Trägermaterial aufgebracht wird, dass die beiden Flächenabschnitte (2, 2a) nur durch die Isolierschicht (6) voneinander getrennt sind und das zweite Trägermaterial (1a) diese Schichten (2, 2a, 6) abdeckt, und dass gegebenenfalls das zweite Trägermaterial (1a) anschliessend entfernt wird.

**9.** Verfahren nach einem der Ansprüche 1 und 8, dadurch gekennzeichnet, dass der erste Flächenabschnitt (2) des gewünschten Schaltungsmusters auf eine auf dem ersten Trägermaterial (1) aufgebrachte Folie von elektrisch leitendem Material mit Hilfe eines ätzmittelbeständigen Klebers aufgedruckt, dass danach in den dazwischenliegenden Abschnitten (10) das elektrisch leitende Material weggeätzt wird, und dass anschliessend auf dem zweiten Trägermaterial (1a) der für die Verbindung mit der zweiten Seite der Isolierschicht (6) bestimmte zweite Flächenabschnitt (2a) des elektrisch leitenden Materials zugeführt und mit dieser Seite verbunden wird.

**10.** Verfahren nach einem der Ansprüche 1, 8 und 9, dadurch gekennzeichnet, dass die Isolierschicht (6) zunächst mit einer positiven Toleranz aufgebracht und anschliessend erst in einem Kontrollvorgang auf die Sollstärke (h), insbesondere durch Heissstempeln, eingestellt wird.

**Claims**

**1.** Process for the production of a circuit layout, in which a first surface portion (2) of an electrically conductive circuit pattern (3) located on a first carrier material (1) has at least one surface area (4), which is covered by a surface area (4a) of a second surface portion (2a) and are only separated from one another by an insulating layer (6) and in which the insulating layer (6) between the two surface areas (4, 4a) is at a maximum as thick as the carrier material (1), characterized in that firstly to the first surface portion (2) is applied in a coating process the insulating layer (6) in the form of an adhesive in liquid or pasty state and that then to this optionally still liquid or pasty insulating layer (6) is applied the second surface portion (2a) of the circuit pattern.

**2.** Process according to claim 1, characterized in that the adhesive is constituted by a heat-activatable and/or etchant-resistant material, particularly a heat-sealing lacquer.

**3.** Process according to one of the claims 1 and 2, characterized in that the insulating layer (6) between the two surface areas (4, 4a) and at least in one area is only applied to the conductive circuit pattern (3), but not to the intermediate portions (10).

**4.** Process according to one of the claims 1 to 3, characterized in that the insulating layer (6) is applied in a thickness of max. 20 micrometres, preferably less than 15 micrometres and in particular between 3 and 7 micrometres.

**5.** Process according to one of the claims 1 to 4, characterized in that the circuit layout is in the form of a resonance label or tag with an inductor and a capacitor and that the two covering surface portions (2, 2a) separated by the insulating layer (6) form the capacitor, the insulating layer (6) preferably having beads (11) projecting between the surface areas (4, 4a).

**6.** Process according to claim 5, characterized in that two further covering surface areas (5, 5a) are brought into electrically conductive connection as contacts by crimping through the insulating layer (6) and preferably the insulating layer (6) has in the vicinity of the contacts holes (6'), along whose edge the two surface areas (5, 5a) are interconnected substantially without any interruption.

**7.** Process according to one of the claims 5 and 6, characterized in that an inductor coil (3) is provided and the covering surface areas (4, 4a or 5, 5a) located within the inductor coil (3) take up less than 40%, preferably less than 25% of the surface (9) surrounded by the coil (3).

EP 0 255 073 B1

8. Process according to claim 1, characterized in that the second surface portion (2a) is placed on a second carrier material (1a), that the second carrier material (1a) is so applied to the first carrier material that the two surface portions (2, 2a) are only separated from one another by the insulating layer (6) and that the second carrier material (1a) covers said layers (2, 2a, 6) and that optionally the second carrier material (1a) is subsequently removed.

9. Process according to one of the claims 1 and 8, characterized in that the first surface portion (2) of the desired circuit pattern is pressed onto a film of electrically conductive material applied to the first carrier material (1) with the aid of an etchant-resistant adhesive, that subsequently in the intermediate portions (10) the electrically conductive material is etched away and that subsequently to the second carrier material (1a) is supplied the second surface portion (2a) of the electrically conducting material intended for the connection with the second side of the insulating layer (6) and is connected to said side.

10. Process according to one of the claims 1, 8 and 9, characterized in that the insulating layer (6) is initially applied with a positive tolerance and subsequently in a control process is adjusted to the desired thickness (h), particularly by hot punching.

**Revendications**

1. Procédé de production d'un circuit dans lequel un premier segment de surface (2) d'un dessin de circuit (3) conducteur de l'électricité, qui se trouve sur un premier matériau de support (1), présente au moins une région de surface (4) qui est recouverte par une région de surface (4a) d'un deuxième segment de surface (2a) - séparées l'une de l'autre uniquement par une couche isolante (6) - et dans lequel la couche isolante (6) située entre les deux régions de surfaces (4, 4a) est d'épaisseur au maximum égale à celle du matériau de support (1), caractérisé en ce que, tout d'abord, on dépose la couche isolante (6) sous la forme d'une colle à l'état liquide ou pâteux sur le premier segment de surface (2), lors d'une opération d'enduction, et qu'on dépose ensuite le deuxième segment de surface (2a) du dessin de circuit sur cette couche isolante (6), éventuellement encore liquide ou pâteuse.

2. Procédé selon la revendication 1, caractérisé en ce qu'on utilise comme colle un matériau pouvant être activé par la chaleur et/ou résistant aux agents de gravure, en particulier une laque de scellement à chaud.

3. Procédé selon une des revendications 1 et 2, caractérisé en ce qu'au moins dans une région, la couche isolante (6) située entre les deux régions de surface (4, 4a) est déposée uniquement sur le dessin de circuit conducteur (3) mais non pas sur les segments (10) intermédiaires.

4. Procédé selon une des revendications 1 à 3, caractérisé en ce que la couche isolante (6) est déposée, en une épaisseur de 20 micromètres au maximum, de préférence de moins de 15 micromètres, et en particulier comprise entre 3 et 7 micromètres.

5. Procédé selon une des revendications 1 à 4, caractérisé en ce que le dispositif de circuit présente la forme d'une étiquette de résonance comprenant un inducteur et un condensateur et en ce que les deux segments de surface (2, 2a) qui se recouvrent mutuellement, séparés par la couche isolante (6), forment le condensateur, la couche isolante (6) présentant de préférence des bourrelets (11) qui font saillie entre les régions de surfaces (4, 4a).

6. Procédé selon la revendication 5, caractérisé en ce que deux autres régions de surfaces (5, 5a) qui se recouvrent mutuellement sont raccordées électriquement, par pincement à travers la couche isolante (6) pour assurer des contacts, et la couche isolante (6) présente de préférence dans la région des contacts des trous (6') le long du bord desquels les deux régions de surfaces (5, 5a) sont réunies l'une à l'autre sensiblement sans interruption.

7. Procédé selon une des revendications 5 et 6, caractérisé en ce qu'il est prévu une bobine d'induction (3) et les régions de surfaces (4, 4a ou 5, 5a) situées à l'intérieur de la bobine d'induction (3) et qui se recouvrent mutuellement, occupent moins de 40 %, de préférence moins de 25 % de la surface (9) entourée par la bobine d'induction (3).

11

**8.** Procédé selon la revendication 1, caractérisé en ce que le deuxième segment de surface (2a) est disposé sur un deuxième matériau de support (1a), en ce que le deuxième matériau de support (1a) est appliqué sur le premier matériau porteur de telle manière que les deux segments de surfaces (2, 2a) soient séparés l'un de l'autre uniquement par la couche isolante (6) et que le deuxième matériau porteur (1a) recouvre ces couches (2, 2a, 6) et que le deuxième matériau de support (1a) est éventuellement éliminé ensuite.

**9.** Procédé selon une des revendications 1 et 8, caractérisé en ce que le premier segment de surface (2) du dessin de circuit choisi est imprimé sur une feuille de matériau conducteur de l'électricité appliquée sur le premier matériau de support (1), à l'aide d'une colle résistante aux agents de gravure, en ce qu'ensuite, le matériau conducteur de l'électricité est enlevé dans les segments (10) intermédiaires et en ce qu'ensuite, on place sur le deuxième matériau de support (1a), le deuxième segment de surface (2a) de matériau conducteur de l'électricité, qui est destiné à être assemblé à la deuxième face de la couche isolante (6), et on l'assemble à cette face.

**10.** Procédé selon les revendications 1, 8 et 9, caractérisé en ce que la couche isolante (6) est tout d'abord déposée avec une tolérance positive et qu'elle n'est ramenée à l'épaisseur de consigne (h) que par la suite, dans une opération de contrôle, de préférence par pressage à chaud.

EP 0 255 073 B1

Fig.1

Fig.2

Fig.3

Fig.4

13

Fig. 5

Fig. 6